# EUROPÄISCHE PATENTSCHRIFT

(11) **EP 1 244 339 B1**
(45) Veröffentlichungstag und Bekanntmachung des Hinweises auf die Patenterteilung: **21.06.2006**
(21) Anmeldenummer: 02090089.0
(22) Anmeldetag: 01.03.2002
(51) Int. Cl.: H05K 5/00, H05K 5/02

(54) **Sicheres Gehäuse für ein elektronisches Gerät**
Security casing for an electronic apparatus
Boîtier de sécurité pour un appareil électronique

(30) Priorität: 21.03.2001 DE 10114528
(43) Veröffentlichungstag der Anmeldung: 25.09.2002
(73) Patentinhaber: Francotyp-Postalia GmbH, 16547 Birkenwerder (DE)
(72) Erfinder: Ansell, Iain, Newmarket, Suffolk CB8 0ES (GB); Cooper, Adrian, St Ives, Cambridgeshire PE27 3JF (GB)

(56) Entgegenhaltungen:
- EP-A- 1 024 682
- DE-A- 4 431 281
- DE-A- 19 623 615

## Beschreibung

Die vorliegende Erfindung betrifft ein sicheres Gehäuse für ein elektronisches Gerät, insbesondere eine Frankiermaschine, mit wenigstens einem ersten Gehäuseteil und einem zweiten Gehäuseteil, der mit dem ersten Gehäuseteil über wenigstens eine Verbindungseinrichtung lösbar verbunden ist.

Bei zahlreichen elektronischen Geräten besteht die Anforderung, dass ihr Innenleben von unbefugtem Zugriff geschützt ist, um zum einen den Benutzer vor einer möglichen Gefährdung zu schützen oder aber auch betrügerische Manipulationen an dem Gerät zu verhindern. Dieses Verhindern unerkannter betrügerischer Manipulationen ist gerade bei Frankiermaschinen besonders wichtig, die letztendlich einen geldwerten Abdruck, nämlich die Frankierung eines Briefes oder dergleichen erzeugen.

Um den Postbeförderer vor größeren Verlusten zu schützen, die durch betrügerische Manipulationen, beispielsweise an den postalischen Registern der Frankiermaschine, welche die Abrechnungsinformation für die mit der Frankiermaschine erzeugten Frankierabdrucke enthalten, entstehen können, weisen Frankiermaschinen oder das zugehörige Abrechnungsmodul in der Regel ein gattungsgemäßes sicheres Gehäuse auf. Dieses sichere Gehäuse verhindert den unautorisierten Zugang zu sicherheitsrelevanten Bereichen der Frankiermaschine. Hierbei versteht es sich, dass sich ein Betrüger zwar trotzdem Zugang zu diesen sicherheitsrelevanten Bereichen verschaffen kann, jedoch schon der Versuch durch entsprechende Spuren an dem Gehäuse oder damit verbundene Teile erkennbar ist, sodass zumindest im Nachhinein schon ein Betrugsversuch nachweisbar ist.

Um das unautorisierte Öffnen oder schon den Versuch eines unautorisierten Öffnens des sicheren Gehäuses erkennbar zu machen, sind beispielsweise herkömmliche Drahtplomben bekannt, mittels derer wenigstens eine die beiden Gehäuseteile verbindende Schraube in bekannter Weise verplombt ist. Diese Lösung weist jedoch den Nachteil auf, dass die Drahtplomben relativ aufwändig bzw. unhandlich sind und gegebenenfalls auch unbeabsichtigt, beispielsweise beim Wechsel des Aufstellortes des Gerätes, beschädigt werden können.

Andererseits ist es beispielsweise bei Heizkostenerfassungseinrichtungen bekannt, stiftartige Verbindungselemente zum Verbinden der Gehäuseteile zu verwenden, welche zum Lösen der Verbindung zwischen den beiden Gehäuseteilen zerstört werden müssen; (siehe z.B. auch EP-A-1 024 682). Diese Varianten weisen wiederum den Nachteil auf, dass sie sich in der Regel auf Grund der Gestaltung der Verbindungsstifte nur für relativ kleine Gehäuse eignen.

Der vorliegenden Erfindung liegt daher die Aufgabe zu Grunde, ein sicheres Gehäuse der eingangs genannten Art zur Verfügung zu stellen, bei dem die oben genannten Nachteile nicht oder zumindest in geringerem Maße auftreten und welches insbesondere bei einfacher Herstellbarkeit ein zuverlässiges Erkennen absichtlicher Manipulationen gewährleistet.

Diese Aufgabe wird ausgehend von einem Gehäuse gemäß dem Oberbegriff des Anspruchs 1 durch die im kennzeichnenden Teil des Anspruchs 1 angegebenen Merkmale gelöst.

Der vorliegenden Erfindung liegt die technische Lehre zu Grunde, dass man ein einfach herzustellendes Gehäuse erhält, welches absichtliche Manipulationen zuverlässig erkennen lässt, wenn zum Verhindern eines unbekannten Öffnens des Gehäuses wenigstens eine an und/oder in dem ersten oder zweiten Gehäuseteil angeordnete, den Zugang zu der Verbindungseinrichtung versperrende Abdeckeinrichtung vorgesehen ist, die nur unter erkennbarer Beschädigung, beispielsweise zumindest teilweise Zerstörung, von dem ersten oder zweiten Gehäuseteil entfernbar ist.

Durch die Abdeckeinrichtung ist zum einen in vorteilhafter Weise sichergestellt, dass absichtliche Manipulationen an dem Gehäuse ohne weiteres erkennbar sind. Zum anderen ermöglicht es die Abdeckeinrichtung, die Verbindungseinrichtung in herkömmlicher Weise zu gestalten, sodass hierfür kein besonderer Aufwand betrieben werden muss, was sich wiederum vorteilhaft auf den Herstellungsaufwand, insbesondere die Herstellungskosten auswirkt.

Die Abdeckeinrichtung hat weiterhin den Vorteil, dass sie relativ klein und einfach ausgebildet sein kann, da sie lediglich den Zugang zu der Verbindungseinrichtung versperren muss. Dies erleichtert die Herstellung sowohl der Abdeckeinrichtung als auch des ersten bzw. zweiten Gehäuseteils erheblich.

Die Verbindungseinrichtung kann in herkömmlicher Weise ausgebildet sein, beispielsweise in Form von einer oder mehreren Schrauben, Haken etc., über welche die beiden Gehäuseteile in herkömmlicher Weise verbunden sind. Im Falle der Schraube muss dann die Abdeckeinrichtung beispielsweise lediglich den ansonsten zum Lösen zugänglichen Schraubenkopf abdecken und kann demgemäss sehr klein, einfach und kompakt gestaltet sein.

Bei bevorzugten Varianten des erfindungsgemäßen Gehäuses ist vorgesehen, dass die Verbindungseinrichtung Befestigungsmittel umfasst, über die sie lösbar an dem ersten Gehäuseteil befestigt ist. Hierdurch ist es in vorteilhafter Weise möglich Verbindungseinrichtungen vorzusehen, bei denen die Verbindung zwischen dem ersten und zweiten Gehäuseteil bei der Herstellung des Gerätes über einen einfacher zu fügenden Verbindungsmechanismus als den der Verbindung zwischen der Verbindungseinrichtung und dem ersten Gehäuseteil möglich ist.

Bei bevorzugten Varianten des erfindungsgemäßen Gehäuses ist vorgesehen, dass die Verbindungseinrichtung nach Art einer Schnappverbindung ausgebildet ist. Hierbei ist dann ein Bestandteil der Schnappverbindung über die Befestigungsmittel an dem ersten Gehäuseteil befestigt. Diese Verbindung kann schon weit vor der weiteren Montage des Gerätes erfolgen, sodass zur Fertigstellung des Gerätes nach Montage des Innenlebens des Gerätes nur noch der zweite Gehäuseteil über besagte Schnappverbindung auf- bzw. angesetzt werden muss.

Es versteht sich jedoch, dass die Bestandteile der Schnappverbindung jeweils fest mit dem zugehörigen Gehäuseteil verbunden sein können und die Abdeckeinrichtung dann lediglich den Zugang durch den ersten oder zweiten Gehäuseteil zu wenigstens einem dieser Bestandteile versperrt, über den, gegebenenfalls unter Verwendung entsprechender Werkzeuge, die Verbindung zwischen den beiden Gehäuseteilen gelöst werden kann.

Die Abdeckeinrichtung kann in beliebiger Weise so mit dem ersten Gehäuseteil verbunden sein, dass sie beim Entfernen von dem ersten Gehäuseteil oder dessen Versuch erkennbar beschädigt, d.h. zumindest teilweise so zerstört bzw. beeinträchtigt wird, dass dies zumindest für einen erfahrenen Betrachter ohne weiteres erkennbar ist. Die Abdeckeinrichtung kann hierzu mit dem ersten Gehäuseteil stoffschlüssig verbunden sein, z.B. verschweißt sein, oder kraftschlüssig verbunden sein, z.B. verklebt sein.

Bei bevorzugten, weil die erkennbare Zerstörung bzw. Beschädigung am einfachsten sicherstellenden Varianten der Erfingung ist die Abdeckeinrichtung formschlüssig mit dem ersten Gehäuseteil verbunden. Weiter vorzugsweise ist die Abdeckeinrichtung über eine nur unter zumindest teilweiser Zerstörung lösbare Schnappverbindung mit dem ersten Gehäuseteil verbunden. Diese Variante hat den Vorteil, dass sich zudem die Verbindung zum ersten Gehäuseteil besonders einfach herstellen lässt.

Es versteht sich im übrigen, dass die genannten Arten der Verbindung zwischen der Abdeckeinrichtung und dem ersten Gehäuseteil natürlich auch beliebig miteinander kombiniert werden können.

Bei günstigen Weiterbildungen des erfindungsgemäßen Gehäuses umfasst die Verbindungseinrichtung wenigstens ein mit dem ersten Gehäuseteil lösbar verbundenes erstes Verbindungselement und wenigstens ein damit zusammenwirkendes zweites Verbindungselement, welches an dem zweiten Gehäuseteil angeordnet ist. Hierdurch lassen sich besonders einfach die oben erwähnten Verbindungen zwischen dem ersten und zweiten Gehäuseteil realisieren, die bei der Herstellung des Gerätes einen einfacher zu fügenden Verbindungsmechanismus nutzen als denjenigen zwischen dem ersten Verbindungselement und dem ersten Gehäuseteil. Auf diese Weise kann die Verbindungseinrichtung beispielsweise einfach nach Art der erwähnten Schnappverbindung ausgebildet werden. Es versteht sich hierbei natürlich, dass auch beide Verbindungselemente lösbar in entsprechender Weise mit dem jeweiligen Gehäuseteil verbunden sein können.

Auf Grund der einfachen Realisierbarkeit ist das erste Verbindungselement vorzugsweise nach Art eines Hakens ausgebildet, der zum Herstellen der Verbindung zwischen dem ersten und zweiten Gehäuseteil in eine Hinterschneidung des zweiten Verbindungselements eingreift. Weiter vorzugsweise ist wenigstens das erste Verbindungselement zum Herstellen einer nach Art einer Schnappverbindung ausgebildeten Verbindung federnd ausgebildet und zusätzlich oder alternativ entsprechend federnd angeordnet, beispielsweise an einem federnden Abschnitt des betreffenden Gehäuseteils befestigt oder durch ein entsprechendes Federelement dort befestigt.

Es versteht sich, dass die genannten Verbindungen zwischen dem ersten und zweiten Gehäuseteil nach Anbringen des Abdeckelements so ausgebildet und angeordnet sind, dass sie nur dann wieder gelöst werden können, wenn das Abdeckelement entfernt wird.

Dies lässt sich vorzugsweise dadurch realisieren, dass die Verbindungseinrichtung einfach innerhalb des Gehäuses angeordnet ist.

Die Verbindungseinrichtung kann aber auch außerhalb des Gehäuses angeordnet sein, wobei dann das Abdeckelement so groß gewählt ist und derart ausgebildet ist, dass es zumindest sämtliche Bereiche der Verbindungseinrichtung abdeckt, über die Verbindung gelöst werden könnte. Vorzugsweise ist das Abdeckelement dabei so groß gewählt und derart ausgebildet, dass es die gesamte Verbindungseinrichtung abdeckt und so vor unbefugten Zugriff schützt.

Bei bevorzugten, weil besonders einfachen und zuverlässigen Varianten des erfindungsgemäßen Gehäuses umfassen die Befestigungsmittel eine Schraubverbindung. Dies stellt zudem auf Grund des regelmäßig sehr robusten Aufbaus sicher, dass die Verbindung zwischen den beiden Gehäuseteilen, beispielsweise zur autorisierten, turnusmäßigen Wartung oder Überprüfung des Gerätes, mehrfach gelöst werden kann, ohne dass hierdurch die Funktionsfähigkeit der Verbindungseinrichtung beeinträchtigt wäre.

Es kann genügen, eine der genannten Verbindungseinrichtungen am bzw. im Gehäuse vorzusehen. Bei besonders bevorzugten Varianten des erfindungsgemäßen Gehäuses sind jedoch zwei oder mehr der beschriebenen Verbindungseinrichtungen vorgesehen. Hierdurch lassen sich besonders einfach zu montierende Gehäuseteile realisieren.

Die vorliegende Erfindung betrifft weiterhin ein elektronisches Gerät nach Anspruch 10, insbesondere eine Frankiermaschine, mit einem entsprechenden erfindungsgemäßen Gehäuse, da sich hier die oben beschriebenen Vorteile in besonderem Maße erzielen lassen.

Eine weitere - gegebenenfalls zusätzliche zu den vorgeschriebenen Varianten einsetzbare und im übrigen einen eigenständig schutzfähigen Erfindungsgedanken darstellende - Möglichkeit, in einfacher Weise sicherzustellen, dass das Gehäuse nicht unbemerkt geöffnet werden kann, liegt darin, an einem Gehäuseteil ein magnetisches Element anzuordnen und ein Erfassungselement zur Erfassung einer Änderung des Magnetfeldes im Bereich des Gerätes vorzusehen, welches mit einem Speicher des Gerätes und/oder einer Verarbeitungseinrichtung des Gerätes zur Entgegennahme der Signale des Erfassungselements verbunden ist.

Hierdurch ist es möglich, das Entfernern des Gehäuseteils zu erfassen, an dem das magnetische Element, beispielsweise ein einfacher Permanentmagnet, angeordnet ist, da sich dabei das Magnetfeld im Bereich des Gerätes ändert. Dieses Erfassen einer dem Entfernen des Gehäuseteils entsprechenden Änderung des Magnetfeldes kann dann durch bzw. in der Verarbeitungseinrichtung des Gerätes oder durch Beschreiben des Speichers registriert und zu einem späteren Zeitpunkt, beispielsweise bei einer Inspektion oder dergleichen, abgefragt und zusätzlich oder alternativ von sich aus angezeigt werden.

Zusätzlich oder alternativ kann natürlich bei Auftreten der dem Entfernen des Gehäuseteils entsprechenden Änderung des Magnetfeldes und damit eines entsprechenden Erfassungssignals des Erfassungselements vorgesehen sein, dass das Gerät in einen bestimmten Betriebszustand, vorzugsweise in einen Sperrzustand, versetzt wird, den der Benutzer nicht ohne eine entsprechende Autorisierung wieder verlassen kann.

Das magnetische Element und das Erfassungselement sind so aufeinander abgestimmt, dass sich eine durch das Erfassungselement erfassbare Änderung des Magnetfeldes ergibt. Bevorzugt ist die Änderung des Magnetfeldes dank der geeigneten Auswahl des magnetischen Elements so charakteristisch, dass die Änderung zuverlässig von anderen Änderungen des Magnetfeldes im Bereiche des Gerätes unterschieden werden kann, die im normalen Betrieb des Gerätes auftreten können.

Das Erfassungselement ist dabei bevorzugt so abgestimmt, dass es nur dann ein entsprechendes Erfassungssignal an den Speicher und/oder die Verarbeitungseinrichtung abgibt, wenn tatsächlich die charakteristische Änderung eintritt, sodass nur diese erfasst werden muss und keine weitere Auswertung bzw. Weiterverarbeitung in der Verarbeitungseinrichtung oder nach Auslesen der registrierten Daten erfolgen muss, welche den registrierten Änderungen des Magnetfeldes entsprechen.

Das Erfassungselement ist bevorzugt auf der Hauptplatine des Gerätes untergebracht, da es so problemlos mit der Verarbeitungseinrichtung bzw. dem Speicher verbunden werden kann. Bevorzugt handelt es sich bei diesem Erfassungselement um einen so genannten Reed-Schalter.

Weitere vorteilhafte Ausgestaltungen der Erfindung ergeben sich aus den Unteransprüchen bzw. der nachstehenden Beschreibung bevorzugter Ausführungsbeispiele, welche auf die beigefügten Zeichnungen Bezug nimmt. Es zeigen:
- Figur 1: einen schematischen Teilschnitt durch eine bevorzugte Ausführung des erfindungsgemäßen Gehäuses;
- Figur 2: einen schematischen Teilschnitt durch eine weitere bevorzugte Ausführung des erfindungsgemäßen Gehäuses;
- Figur 3: einen schematischen Teilschnitt durch eine dritte bevorzugte Ausführung des erfindungsgemäßen Gehäuses.

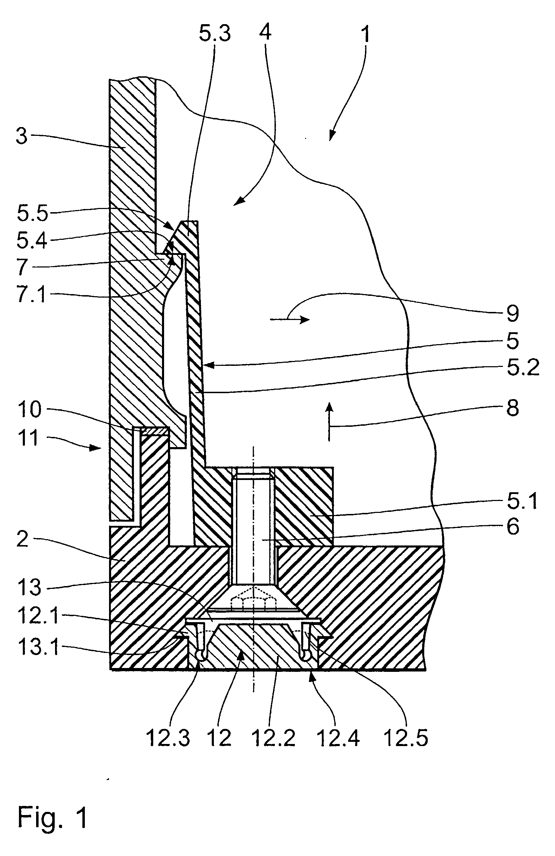

Figur 1 zeigt einen schematischen Teilschnitt durch eine bevorzugte Ausführung des erfindungsgemäßen Gehäuses 1 einer Frankiermaschine mit einem ersten Gehäuseteil 2 und einem zweiten Gehäuseteil 3, die über eine im Innern des Gehäuses 1 angeordnete Verbindungseinrichtung 4 miteinander verbunden sind.

Die Verbindungseinrichtung 4 ist nach Art einer Schnappverbindung ausgebildet. Sie umfasst ein erstes Verbindungselement 5, das über ein Befestigungsmittel in Form einer Befestigungsschraube 6 an dem ersten Gehäuseteil 2 befestigt ist, und ein zweites Verbindungselement 7.

Das erste Verbindungselement 5 ist nach Art eines Hakens ausgebildet. Hierzu weist es ein Basiselement 5.1 auf, in den die Befestigungsschraube 6 eingeschraubt ist. Ausgehend von diesem Basiselement erstreckt sich in einer ersten Richtung 8 ein Verbindungsarm 5.2, an dessen freien Ende 5.3 ein hakenförmiger erster Absatz 5.4 angeordnet ist.

Dieser erste Absatz 5.4 wirkt zum Herstellen der Verbindung zwischen den beiden Gehäuseteilen 2 und 3 mit einer entsprechenden Hinterschneidung des zweiten Verbindungselements 7 in Form eines an dem zweiten Gehäuseteil 3 angeformten zweiten Absatzes 7.1 zusammen. Die Wirkflächen der beiden Absätze 5.4 und 7.1 verlaufen senkrecht zur ersten Richtung 8, wodurch sie die beiden Gehäuseteile 2 und 3 in dieser Richtung zueinander verriegeln.

Der Verbindungsarm 5.2 ist aus einem ausreichend elastischen Material gebildet, so dass er quer zur ersten Richtung entlang einer zweiten Richtung 9 federn kann.

Beim Zusammenfügen der beiden Gehäuseteile 2 und 3 entgegen der ersten Richtung 8 wird der Verbindungsarm 5.2 infolge des Kontakts seiner zur ersten Richtung geneigt verlaufenden Anlauffläche 5.5 in der zweiten Richtung ausgelenkt, bevor er schließlich am Ende des Fügevorgangs in die gezeigte Position zurückschnappt.

Der Verbindungsarm 5.2 ist so ausgebildet, dass er im gezeigten Zustand entgegen der zweiten Richtung 9 gegen den zweiten Absatz 7.1 vorgespannt ist, so dass es nicht zu einem unbeabsichtigten Lösen der Verbindung kommen kann.

Entlang der ersten Richtung besteht eine Vorspannung zwischen den beiden Absätzen 5.4 und 7.1, die aus den elastischen Rückstellkräften einer elastischen Zwischenlage 10 zwischen den beiden Gehäuseteilen 2 und 3 resultiert. Diese Zwischenlage stellt zum einen eine spielfreie Verbindung zwischen den Gehäuseteilen 2 und 3 sicher. Zum anderen ermöglicht sie ein einfaches Einrasten der Schnappverbindung, da die beiden Gehäuseteile 2 und 3 dank ihrer elastischen Verformbarkeit beim Zusammenfügen zunächst weiter als dargestellt entgegen der ersten Richtung 8 aufeinander zu bewegt werden können.

Die Fixierung der beiden Gehäuseteile 2 und 3 entlang der zweiten Richtung 9 wird durch eine Überlappung 11 sichergestellt, die zudem gewährleistet, dass kein Spalt entsteht, durch den in den Innenraum des Gehäuses 1 eingedrungen werden könnte.

Um sicherzustellen, dass das Gehäuse 1 nicht unerkannt durch unbefugte Personen geöffnet werden kann, ist der Zugang zum Kopf der Befestigungsschraube 6 durch eine Abdeckeinrichtung in Form einer Abdeckscheibe 12 versperrt, die in eine Ausnehmung 13 im ersten Gehäuseteil 2 eingesetzt ist.

Diese Abdeckscheibe 12 kann nur aus der Ausnehmung 13 entfernt werden, indem sie zumindest sichtbar beschädigt wird. In der Regel wird sie hierbei zerstört. Um dies zu gewährleisten, weist die Abdeckscheibe 12 an ihrem Umfang federnde Widerhaken 12.1 auf, die unter Vorspannung in entsprechende Hinterschneidungen 13.1 der Ausnehmung 13 einrasten. Diese Widerhaken 12.1 weisen an ihrem Übergang zum Grundkörper 12.2 der Abdeckscheibe 12 Schwächungsbereiche 12.3 auf. Diese Schwächungsbereiche 12.3 ermöglichen bzw. erleichtern zum einen das Federn der Widerhaken 12.1. Zum anderen stellen sie sicher, dass einer oder mehrere der Widerhaken 12.1 beim Entfernen der Abdeckscheide 12 aus der Ausnehmung 13 vom Grundkörper 12.2 abreißen, wodurch eine erkennbare Beschädigung der Abdeckscheibe 12 entsteht.

Die Oberfläche 12.4 der Abdeckscheibe 12 schließt bündig mit dem ersten Gehäuseteil 2 ab, sodass die Gefahr einer unbeabsichtigten Beschädigung der Abdeckscheibe 12 in einfacher Weise stark verringert ist. Um dieses Risiko noch weiter zu reduzieren, kann die Abdeckscheibe bei anderen Varianten auch in dem ersten Gehäuseteil versenkt sein.

Die Oberfläche 12.4 der Abdeckscheibe 12 ist glatt, d.h. ohne Hinterschneidungen oder Vorsprünge ausgebildet, sodass sie keinen Ansatzpunkt für ein Werkzeug zum Entfernen bietet. Hierdurch ist sichergestellt, dass zum Entfernen der Abdeckscheibe 12 aus der Ausnehmung 13 mangels anderer Ansatzpunkte mit einem entsprechenden Werkzeug in der Regel in die Abdeckscheibe 12 eingestochen werden muss, um einen Ansatzpunkt zu schaffen. Hierdurch entsteht selbstverständlich ebenfalls eine erkennbare Beschädigung der Abdeckscheibe 12.

Es versteht sich jedoch, dass bei anderen Varianten der Erfindung auch schon eine entsprechende Hinterschneidung oder dergleichen als Ansatzpunkt für ein Werkzeug zum Entfernen der Abdeckscheibe vorgesehen sein kann.

Die beschriebene Gestaltung der Abdeckscheibe dürfte ausreichen, um einen Großteil der Betrugsversuche zuverlässig zu vereiteln oder zumindest nicht unbemerkt zu lassen. Um die Wahrscheinlichkeit eines nicht erkennbaren Entfernens der Abdeckscheibe 12 aus der Ausnehmung 13 noch weiter zu verringern, kann bei weiteren Varianten der Erfindung noch vorgesehen sein, dass zumindest die Bereiche zwischen den Widerhaken 12.1 der Abdeckscheibe 12 und dem Grundkörper 12.2 der Abdeckscheibe 12 ganz oder teilweise vor Einsetzen der Abdeckscheibe 12 oder durch eine entsprechende Öffnung in der Abdeckscheibe mit einer aushärtenden Masse zu verfüllen, wie dies durch die Kontur 12.5 angedeutet ist, um so das spätere Rückfedern der Widerhaken 12.1 und damit das Lösen der Abdeckscheibe 12 durch entsprechende, in den Spalt zwischen Abdeckscheibe 12 und Gehäuse 1 eingeführte Werkzeuge zu unterbinden. Gegebenenfalls kann auch der gesamte noch verbleibende Raum der Ausnehmung 13 verfüllt werden.

Um die Verbindung zwischen den beiden Gehäuseteilen 2 und 3 zu lösen, beispielsweise zu Inspektions- oder Wartungszwecken, muss zunächst die Abdeckscheibe 12 entfernt werden, wobei diese zumindest sichtbar beschädigt wird. Dann kann die Befestigungsschraube 6 gelöst werden, wodurch auch die Verbindung zwischen den beiden Gehäuseteilen 2 und 3 gelöst wird und das zweite Gehäuseteil 3 in der ersten Richtung 8 von dem ersten Gehäuseteil 2 abgehoben werden kann.

Bei dem gezeigten Gehäuse 1 sind mehrere solcher Verbindungseinrichtungen 4 vorgesehen, sodass diese Prozedur für alle diese Verbindungseinrichtungen 4 erfolgen muss, bevor die beiden Gehäuseteile 2 und 3 voneinander getrennt werden können.

Es versteht sich, dass bei anderen Varianten des erfindungsgemäßen Gehäuses auch mehrere Verbindungsarme des ersten Verbindungselements an einem gemeinsamen Basiselement angeordnet sein können. Dieses Basiselement kann dann wiederum auch durch mehrere Befestigungselemente an dem ersten Gehäuseteil befestigt sein. Weiterhin kann eine Abdeckeinrichtung für mehrere Befestigungselemente vorgesehen sein.

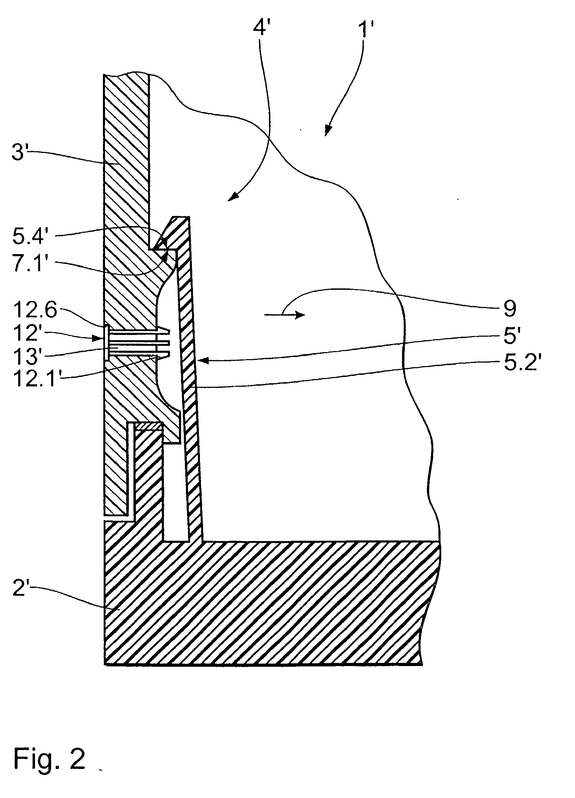

Figur 2 zeigt einen schematischen Teilschnitt durch eine weitere bevorzugte Ausführung des erfindungsgemäßen Gehäuses 1' einer Frankiermaschine. Diese Ausführung entspricht in ihrem Aufbau und ihrer Funktionsweise grundsätzlich derjenigen aus Figur 1, sodass hier lediglich auf die Unterschiede eingegangen werden soll.

Der Unterschied besteht darin, dass der federnde Verbindungsarm 5.2' des ersten Verbindungselements 5' der Verbindungseinrichtung 4' fest mit dem ersten Gehäuseteil 2' verbunden, im vorliegenden Fall an dem ersten Gehäuseteil 2' angeformt ist.

Zum Lösen der Verbindung zwischen dem ersten Gehäuseteil 2' und dem zweiten Gehäuseteil 3' ist eine Öffnung 13' im zweiten Gehäuseteil 3' vorgesehen, durch die ein - nicht dargestelltes - Werkzeug geführt werden kann, um den Verbindungsarm 5.2' in der zweiten Richtung 9 von dem zweiten Gehäuseteil 3' zu entfernen und so den Eingriff zwischen dem ersten Absatz 5.4' und dem zweiten Absatz 7.1' zu lösen.

Diese Öffnung 13' ist durch eine Abdeckeinrichtung in Form eines Deckels 12' mit federnden Widerhaken 12.1' verschlossen. Dieser Deckel 12' kann wiederum nur entfernt werden, indem er zumindest sichtlich beschädigt, in der Regel aber zerstört wird. Das Lösen des Deckels 12' durch das Rückfedern der Widerhaken 12.1' mittels entsprechender, in den Spalt zwischen Deckel 12' und Gehäuse 1' eingeführter Werkzeuge wird hier durch den Absatz 12.6 des Deckels 12' unterbunden.

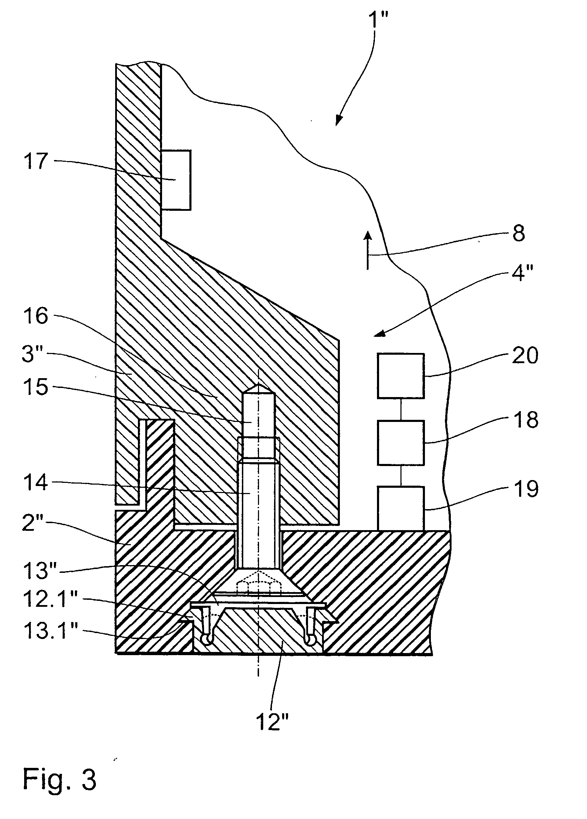

Figur 3 zeigt einen schematischen Teilschnitt durch noch eine weitere bevorzugte Ausführung des erfindungsgemäßen Gehäuses 1" einer Frankiermaschine.

Bei dieser Ausführung ist die Verbindungseinrichtung 4" von einer einfachen Verschraubung gebildet, bei der eine Verbindungsschraube 14 als erstes Verbindungselement in die Gewindebohrung 15 eines Vorsprungs 16 am zweiten Gehäuseteil 3" als zweites Verbindungselement eingeschraubt ist.

Um sicherzustellen, dass das Gehäuse 1" nicht unerkannt durch unbefugte Personen geöffnet werden kann, ist der Zugang zum Kopf der Befestigungsschraube 14 durch eine Abdeckeinrichtung in Form einer Abdeckscheibe 12" versperrt, die in eine Ausnehmung 13" im ersten Gehäuseteil 2" eingesetzt ist.

Diese Abdeckscheibe 12" kann nur aus der Ausnehmung 13" entfernt werden, indem sie zumindest sichtbar beschädigt wird. In der Regel wird sie hierbei zerstört. Um dies zu gewährleisten, weist die Abdeckscheibe 12" an ihrem Umfang federnde Widerhaken 12.1" auf, die unter Vorspannung in entsprechende Hinterschneidungen 13.1" der Ausnehmung 13" einrasten.

Um die Verbindung zwischen den beiden Gehäuseteilen 2" und 3" zu lösen, beispielsweise zu Inspektions- oder Wartungszwecken, muss zunächst die Abdeckscheibe 12" entfernt werden, wobei diese zumindest sichtbar beschädigt wird. Dann kann die Befestigungsschraube 14 gelöst werden, wodurch auch die Verbindung zwischen den beiden Gehäuseteilen 2" und 3" gelöst wird und das zweite Gehäuseteil 3" in der ersten Richtung 8 von dem ersten Gehäuseteil 2" abgehoben werden kann.

Als weitere Sicherung gegen ein unbemerktes Öffnen des Gehäuses 1" ist an dem zweiten Gehäuseteil 3" ein magnetisches Element in Form eines Permanentmagneten 17 angeordnet und weiterhin ein mit der zentralen Verarbeitungseinrichtung 18 der Frankiermaschine 1" verbundenes Erfassungselement in Form eines Reed-Schalters 19 vorgesehen. Dieser Reed-Schalter 19 ist wie die Verarbeitungseinrichtung 18 an dem ersten Gehäuseteil 2" angeordnet und erfasst eine Änderung des Magnetfeldes im Bereich der Frankiermaschine 1".

Der Reed-Schalter 19 gibt bei einer Änderung des Magnetfeldes, die dem Entfernen des mit dem Magneten 17 versehenen zweiten Gehäuseteils 3" von dem ersten Gehäuseteil 2" entspricht, ein entsprechendes Signal an die Verarbeitungseinrichtung 18 ab. Diese Verarbeitungseinrichtung 18 registriert dieses Signal und legt eine entsprechende Information in einem mit ihr verbundenen Speicher 20 ab, der zu einem späteren Zeitpunkt, beispielsweise bei einer Inspektion oder einer Verbindung mit einer entfernten Datenzentrale, ausgelesen wird, wodurch das Öffnen des Gehäuses dann erkennbar wird.

Es versteht sich, dass bei anderen Varianten auch vorgesehen sein kann, dass bei Auftreten der dem Entfernen des zweiten Gehäuseteils entsprechenden Änderung des Magnetfeldes und damit eines entsprechenden Erfassungssignals des Reed-Schalters die Frankiermaschine in einen bestimmten Betriebszustand, vorzugsweise in einen Sperrzustand, versetzt wird, den der Benutzer nicht ohne eine entsprechende Autorisierung wieder verlassen kann.

Die Feldstärke des Magneten 17 ist so auf den Reed-Schalter 19 abgestimmt, dass sich durch eine Bewegung des Magneten 17 relativ zum Reed-Schalter 19 eine derart charakteristische Änderung des Magnetfeldes ergibt, dass diese Änderung zuverlässig von anderen Änderungen des Magnetfeldes im Bereich der Frankiermaschine 1" unterschieden werden kann, die im normalen Betrieb des Gerätes auftreten können.

Der Reed-Schalter 19 ist dabei so abgestimmt, dass er nur dann ein entsprechendes Erfassungssignal an die Verarbeitungseinrichtung 18 abgibt, wenn tatsächlich die geschilderte charakteristische Änderung eintritt, sodass nur diese erfasst und weitergegeben wird.

Es versteht sich, dass bei anderen Varianten das Erfassungselement seine erfassten Änderungen einfach an die Verarbeitungseinrichtung weitergeben kann. Die Auswertung, ob eine charakteristische Änderung eingetreten ist kann dann durch die Verarbeitungseinrichtung der Frankiermaschine oder nach Auslesen der registrierten Daten in einer externen Einrichtung erfolgen.

Der Reed-Schalter 19 ist zusammen mit der Verarbeitungseinrichtung 18 und dem Speicher 20 auf der - nicht dargestellten - Hauptplatine der Frankiermaschine 1" untergebracht, da sie hierdurch problemlos miteinander verbunden werden können. Es versteht sich jedoch, dass er bei anderen Varianten der Erfindung auch an beliebigen anderen Orten angeordnet sein kann. Es muss lediglich sichergestellt sein, dass er an einem Teil der Frankiermaschine angeordnet ist, welcher beim Entfernen des Gehäuseteils mit dem Magneten nicht zusammen mit diesem Gehäuseteil bewegt wird.

Obwohl die Erfindung in den vorstehenden Beispielen bevorzugter Ausführungen stets im Zusammenhang mit Frankiermaschinen beschrieben wurde, versteht es sich, dass sie jedoch auch in Verbindung mit beliebigen anderen Geräten, insbesondere elektronischen Geräten, einsetzbar ist.

## Patentansprüche

1. Sicheres Gehäuse für ein elektronisches Gerät, insbesondere eine Frankiermaschine, mit wenigstens einem ersten Gehäuseteil (2; 2'; 2") und einem zweiten Gehäuseteil (3; 3'; 3"), der mit dem ersten Gehäuseteil (2; 2'; 2") über wenigstens eine Verbindungseinrichtung (4; 4'; 4") lösbar verbunden ist, **dadurch gekennzeichnet, dass** zum Verhindern eines unbemerkten Öffnens des Gehäuses (1; 1'; 1") wenigstens eine an und/oder in dem ersten oder zweiten Gehäuseteil (2, 3; 2', 3'; 2", 3") angeordnete, den Zugang zu der Verbindungseinrichtung (4; 4'; 4") versperrende Abdeckeinrichtung (12; 12'; 12") vorgesehen ist, die nur unter erkennbarer Beschädigung von dem ersten oder zweiten Gehäuseteil (2, 3; 2', 3'; 2", 3") entfernbar ist.

2. Gehäuse nach Anspruch 1, **dadurch gekennzeichnet, dass** die Verbindungseinrichtung (4) Befestigungsmittel (6) umfasst, über die sie lösbar an dem ersten Gehäuseteil (2) befestigt ist.

3. Gehäuse nach Anspruch 1 oder 2, **dadurch gekennzeichnet, dass** die Verbindungseinrichtung (4; 4') nach Art einer Schnappverbindung ausgebildet ist.

4. Gehäuse nach einem der vorhergehenden Ansprüche, **dadurch gekennzeichnet, dass** die Abdeckeinrichtung (12; 12'; 12") über eine nur unter erkennbarer Beschädigung lösbare Schnappverbindung mit dem ersten oder zweiten Gehäuseteil (2, 3; 2', 3'; 2", 3") verbunden ist.

5. Gehäuse nach einem der vorhergehenden Ansprüche, **dadurch gekennzeichnet, dass** die Verbindungseinrichtung (4) wenigstens ein mit dem ersten Gehäuseteil (2) lösbar verbundenes erstes Verbindungselement (5) und wenigstens ein damit zusammenwirkendes zweites Verbindungselement (7) umfasst, welches an dem zweiten Gehäuseteil (3) angeordnet ist.

6. Gehäuse nach Anspruch 5, **dadurch gekennzeichnet, dass** das erste Verbindungselement (5) nach Art eines Hakens ausgebildet ist, der zum Herstellen der Verbindung zwischen dem ersten und zweiten Gehäuseteil (2, 3) in eine Hinterschneidung des zweiten Verbindungselements (7) eingreift.

7. Gehäuse nach Anspruch 6, **dadurch gekennzeichnet, dass** wenigstens das erste Verbindungselement (5) zum Herstellen einer nach Art einer Schnappverbindung ausgebildeten Verbindung federnd ausgebildet und/oder angeordnet ist.

8. Gehäuse nach einem der vorhergehenden Ansprüche, **dadurch gekennzeichnet, dass** die Verbindungseinrichtung (4; 4'; 4") innerhalb des Gehäuses (1; 1'; 1") angeordnet ist.

9. Gehäuse nach einem der vorhergehenden Ansprüche, **dadurch gekennzeichnet, dass** die Befestigungsmittel (6) eine Schraubverbindung umfassen.

10. Elektronisches Gerät mit einem sicheren Gehäuse nach einem der vorhergehenden Ansprüche.

## Claims

1. A secure housing for an electronic appliance, especially a franking machine, comprising at least a first housing part (2; 2'; 2") and a second housing part (3; 3'; 3") that is separably connected to the first housing part (2; 2'; 2") by means of at least one connecting device (4; 4'; 4"), **characterized in that**, for preventing an unnoticed opening of the housing (1; 1'; 1"), there is provided, on and/or in the first or second housing part (2, 3; 2', 3'; 2", 3"), at least one covering device (12; 12'; 12") blocking access to the connecting device (4; 4'; 4") that can only be detached from the first or second housing part (2, 3; 2', 3'; 2", 3") by causing visible damage.

2. A housing according to Claim 1, **characterized in that** the connecting device (4) includes fixing means (6) by means of which it is separably fixed to the first housing part (2).

3. A housing according to Claim 1 or 2, **characterized in that** the connecting device (4; 4') is designed in the form of a snap connection.

4. A housing according to one of the preceding claims, **characterized in that** the covering device (12; 12 ; 12") is connected to the first or second housing part (2, 3; 2', 3'; 2", 3") by means of a snap connection that can only be detached by causing visible damage.

5. A housing according to one of the preceding claims, **characterized in that** the connecting device (4) comprises at least one first connecting element (5) separably connected to the first housing part (2) and at least on second connecting element (7) separably connected to the second housing part (3) and interacting with said first connecting element (5).

6. A housing according to Claim 5, **characterized in that** the first connecting element (5) is designed in the form of a hook that engages in an undercut of the second connecting element (7) for connecting the first to the second housing part (2, 3).

7. A housing according to Claim 6, **characterized in that** at least the first connecting element (5) is designed and/or arranged in a springy manner for establishing a snap-type connection.

8. A housing according to one of the preceding claims, **characterized in that** the connecting device (4; 4'; 4") is arranged within the housing (1; 1'; 1").

9. A housing according to one of the preceding claims, **characterized in that** the fixing means (6) comprise a screw connection.

10. An electronic appliance having a secure housing according to one of the above claims.

## Revendications

1. Coffret sécurisé pour un appareil électronique, en particulier pour une machine à affranchir le courrier, avec au moins une première pièce de boîtier (2; 2'; 2") et une seconde pièce de boîtier (3; 3'; 3"), qui, prévu pour être détaché, est raccordé avec la première pièce de boîtier (2; 2'; 2") par au moins un dispositif de raccordement (4; 4'; 4"), **caractérisée en ce qu'**au moins un dispositif de recouvrement (12; 12'; 12") de bloquage d'accès au dispositif de raccordement (4; 4'; 4"), démontable seulement en cas d'une détérioration perceptible de la première ou de la deuxième pièce de boîtier (2; 3; 2'; 3'; 2"; 3 "), est prévu au niveau et/ou dans la première ou dans la seconde pièce de boîtier (2; 3; 2'; 3'; 2"; 3") pour éviter une ouverture non décelée du coffret (1; 1'; 1").

2. Coffret, selon la spécification 1, **caractérisé en ce que**, le dispositif de raccordement (4) contient des matériels de fixation (6), par lesquels il est fixé de manière détachable à la première pièce de boîtier (2).

3. Coffret, selon la spécification 1 ou 2, **caractérisé en ce que**, le dispositif de raccordement (4; 4') est formé à la manière d'un assemblage à encliquetage.

4. Coffret, selon une des spécifications précédentes, **caractérisé en ce que**, le dispositif de recouvrement (12; 12'; 12") est raccordé par un assemblage à encliquetage, démontable seulement en cas d'une détérioration perceptible, avec la première ou la seconde pièce de boîtier (2; 3; 2'; 3'; 2"; 3").

5. Coffret, selon une des spécifications précédentes, **caractérisé en ce que**, le dispositif de raccordement (4) comprend au moins un premier raccord (5) lié de manière démontable avec la première pièce de boîtier (2), et au moins un deuxième raccord (7) ainsi concourant, qui est disposé au niveau de la seconde pièce de boîtier (3).

6. Coffret, selon la spécification 5, **caractérisé en ce que**, le premier raccord (5) est formé à la manière d'un crochet, qui intervient pour le raccordement entre la première ou la seconde pièce de boîtier (2, 3) dans une contre-dépouille du deuxième raccord (7).

7. Coffret, selon la spécification 6, **caractérisé en ce que**, le premier raccord (5) au moins est développé et/ou disposé sur ressorts pour effectuer un assemblage produit à la manière d'un assemblage à encliquetage.

8. Coffret, selon une des spécifications précédentes, **caractérisé en ce que**, le dispositif de raccordement (4; 4'; 4") est disposé à l'intérieur du boîtier (1; 1'; 1").

9. Coffret, selon une des spécifications précédentes, **caractérisé en ce que**, les matériels de fixation (6) comprennent un raccord à vis.

10. Appareil électronique avec un coffret sécurisé, selon une des spécifications précédentes.
